# EUROPEAN PATENT APPLICATION

(11) **EP 4 815 716 A1**
(43) Date of publication of application: **30.09.2026**
(21) Application number: 25223652.6
(22) Date of filing: 16.12.2025
(51) Int. Cl.: H10W 90/10, H10W 90/00, H10W 70/60, H10W 72/90

(54) **MIDDLE LEVEL INTERCONNECT ARCHITECTURE FOR PANEL LEVEL INTERPOSER INTEGRATION**

(30) Priority: 28.03.2025 US 202519093607
(71) Applicant: Intel Corporation, Santa Clara, CA 95054 (US)
(72) Inventor: ECTON, Jeremy D., Gilbert, 85298 (US)
(74) Representative: 2SPL Patentanwälte PartG mbB

(57) **Abstract**

Embodiments disclosed herein include an apparatus that comprises a component embedded in a substrate, and a first die on a first surface of the substrate. In an embodiment, a layer is on a second surface of the substrate that is opposite from the first surface. In an embodiment, a pad is on the layer, and the pad extends away from the layer. In an embodiment, a liner is on a sidewall of the pad.

## Description

### BACKGROUND

Microelectronic packages with smaller form factors and high efficiency are increasing in popularity and are driving advances in heterogeneous chip integration in order to meet the demands. For example, multichip packaging architectures, such as silicon interposer, embedded bridge die architectures, and/or 2.5D and 3D heterogeneous chip integration are some solutions that have been proposed to achieve these design goals. Embedded bridge architectures are cost-effective approaches that allow for in-package high density interconnects between heterogeneous chips, and they provide extremely high I/O and well controlled electrical interconnect paths between multiple dice.

An alternative approach is to take all embedded bridges and put them into a composite high bridge count bridge patch, which is fabricated through a glass carrier assisted process that takes advantage of significantly better total thickness variation (TTV) and bump thickness variation (BTV) control. Chiplets or CPU dies are then assembled on top of the high bridge count patch to form a 3D package through chip-on-wafer or chip-on-panel bonding technologies.

Enabling the assembly of the bridge patch and other patch on interposer architecture has proven challenging utilizing conventional methodologies. For example, the midlevel interconnect (MLI) bonding between the bridge patch and an underlying substrate is problematic due to solder bridging or the like. As such, yields may be low.

### BRIEF DESCRIPTION OF THE DRAWINGS

Figure 1A is a cross-sectional illustration of an electronic system that comprises an embedded bridge patch that is being coupled to an underlying substrate, in accordance with an embodiment.
Figure 1B is a cross-sectional illustration of an electronic system that comprises an embedded bridge patch with protruding midlevel interconnect (MLI) pads that are being coupled to an underlying substrate, in accordance with an embodiment.
Figure 1C is a cross-sectional illustration of an embedded bridge patch with protruding MLI pads that have tapered sidewalls, in accordance with an embodiment.
Figures 2A - 2H are a series of cross-sectional illustrations that depict a process for forming an embedded bridge patch with protruding MLI pads that comprise tapered sidewalls, in accordance with an embodiment.
Figures 3A - 3N are a series of cross-sectional illustrations that depict a process for forming an embedded bridge patch with protruding MLI pads that have a liner along the sidewalls, in accordance with an embodiment.
Figures 4A - 4G are a series of cross-sectional illustrations that depict a process for forming a protruding MLI pad with an etchstop layer, in accordance with an embodiment.
Figure 4H is a flow diagram that depicts a process for forming a protruding MLI pad with an etchstop layer, in accordance with an embodiment.
Figures 5A - 5G are a series of cross-sectional illustrations that depict a process for forming a protruding MLI pad with a sidewall liner, in accordance with an embodiment.
Figure 5H is a flow diagram that depicts a process for forming a protruding MLI pad with a sidewall liner, in accordance with an embodiment.
Figure 6 is a cross-sectional illustration of an electronic system with an embedded bridge patch and protruding MLI pads , in accordance with an embodiment.
Figure 7 is a schematic of a computing device built in accordance with an embodiment.

### EMBODIMENTS OF THE PRESENT DISCLOSURE

Described herein are protruded bumps for midlevel interconnects (MLIs) that are formed with an MLI first process, in accordance with various embodiments. In the following description, various aspects of the illustrative implementations will be described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials and configurations are set forth in order to provide a thorough understanding of the illustrative implementations. However, it will be apparent to one skilled in the art that the present disclosure may be practiced without the specific details. In other instances, well-known features are omitted or simplified in order not to obscure the illustrative implementations.

Various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Various embodiments or aspects of the disclosure are described herein. In some implementations, the different embodiments are practiced separately. However, embodiments are not limited to embodiments being practiced in isolation. For example, two or more different embodiments can be combined together in order to be practiced as a single device, process, structure, or the like. The entirety of various embodiments can be combined together in some instances. In other instances, portions of a first embodiment can be combined with portions of one or more different embodiments. For example, a portion of a first embodiment can be combined with a portion of a second embodiment, or a portion of a first embodiment can be combined with a portion of a second embodiment and a portion of a third embodiment.

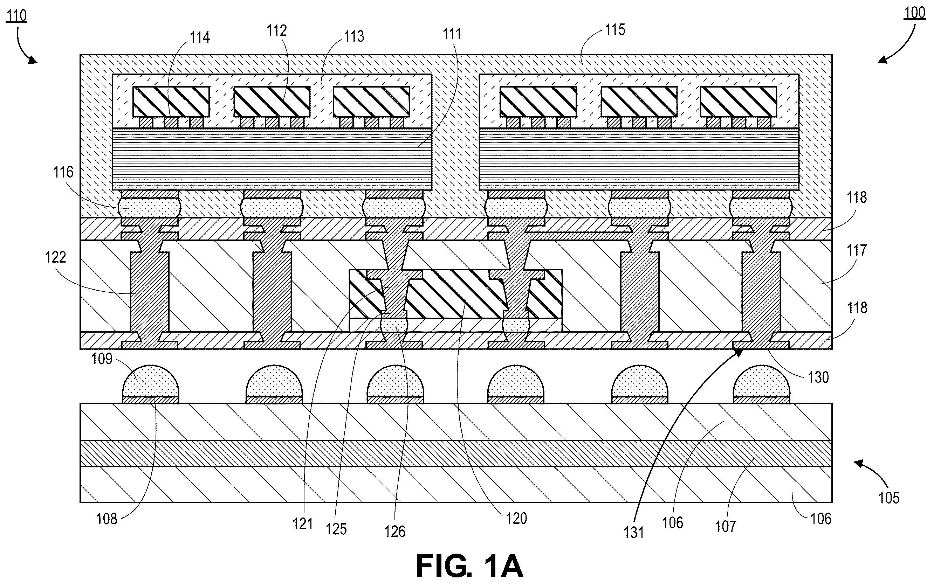

As noted above, advanced semiconductor packaging solutions are trending towards the use of multichip patches in order to provide the desired scaling and data bandwidth transfer for advanced microelectronic systems. Currently, the multichip patch is electrically coupled to an underlying substrate (e.g., an interposer or a package substrate) through midlevel interconnect (MLI) bumps. An example of such a multichip patch is shown in Figure 1A.

Referring now to Figure 1A, a cross-sectional illustration of an electronic system 100 is shown, in accordance with an embodiment. In an embodiment, the electronic system 100 comprises a multichip patch 110 that is being coupled to an underlying substrate 105. The underlying substrate 105 may be a package substrate (e.g., with a core 107 and overlying and/or underlying buildup layers 106). The core 107 may be a glass core, an organic core, or the like. In an embodiment, the substrate 105 may also comprise an interposer or the like. In an embodiment, pads 108 of the substrate 105 may comprise MLI interconnects 109, such as solder balls or the like.

In an embodiment, the multichip patch 110 may comprise a bridge 120 that is embedded in a layer 117. The bridge 120 may comprise vias 121 in some embodiments. The layer 117 may comprise a mold material, buildup film layers, and/or the like. In an embodiment, vias 122 may be formed through at least a portion of a thickness of the layer 117. Redistribution layers (RDLs) 118 or other routing layers may be provided over and/or under the layer 117. In an embodiment, the RDLs 118 may comprise electrically conductive routing. In some embodiments, the bottom pads 125 of the bridge 120 may be electrically coupled to the electrically conductive routing in the underlying RDL 118 by an interconnect 126, such as a solder interconnect or the like.

In an embodiment, the bridge 120 may electrically couple a pair of die complexes to each other. For example, each die complex may comprise a single die 112 or a plurality of dies 112. In the embodiment shown in Figure 1A, each die complex comprises a set of three dies 112 that are electrically coupled to an interposer substrate 111 by interconnects 114. The dies 112 may be embedded in a mold layer 113. Interconnects 116 may electrically couple the die complexes to pads on the top RDL 118. The die complexes may also be embedded in a mold layer 115.

In an embodiment, MLI pads 130 may be provided in the bottom RDL 118. As shown, the MLI pads 130 have an exposed surface 131 that is substantially coplanar with a bottom surface of the RDL that faces the substrate 105. The coplanar relationship between the surfaces may be the result of an fabrication process that forms the RDL 118 and the MLI pads 130 on the same surface (e.g., a carrier) during manufacture of the multichip patch 110.

Substantially coplanar surfaces for the MLI pads 130 and the bottom RDL 118 may result in poor MLI interconnect 109 yield during bonding. For example, the MLI interconnect 109 may not be well confined to the MLI pads 130, which can result in solder bridging or the like. Some solutions have proposed protruding MLI pads 130 in order to improve the confinement of the MLI interconnect 109 and prevent solder bridging. Following traditional approaches, protruded MLI pads 130 are fabricated last after die 112 placement and first level interconnect (FLI) patterning, which impacts yield. For example, such embodiments rely on etching the dielectric material of the RDL 118. During this etching process, some of the copper of the MLI pads 130 may also etch since the etching chemistry is not perfectly selective to the dielectric material. This can lead to copper redeposition along RDL 118 and form electrical shorts between MLI interconnects 109. Additionally, it is challenging to remove the redeposited copper from the RDL 118 as the redeposited copper may become deeply anchored in the dielectric. Further, thickness variation of the RDL 118 may lead to challenges with respect to controlling the etching of the RDL 118. Dielectric etching may also undercut the MLI pads 130, which can result in reliability concerns due to a high risk of cracking the MLI pad 130.

Accordingly, embodiments disclosed herein may include electronic systems 100 with protruding MLI pads 130 that are formed at the beginning of the process flow with an MLI pad 130 first process. As such, the benefits of the protruded MLI pads 130 may be obtained without the need to etch the dielectric material of the RDL 118 in a way that leads to redeposition of copper. For example, an etchstop layer or other passivation layer may be provided over the MLI pads 130 in order to provide protection during any necessary etching processes. In some embodiments, when a dielectric material is etched the dielectric material is completely removed. This avoids issues with etch control and/or copper redeposition.

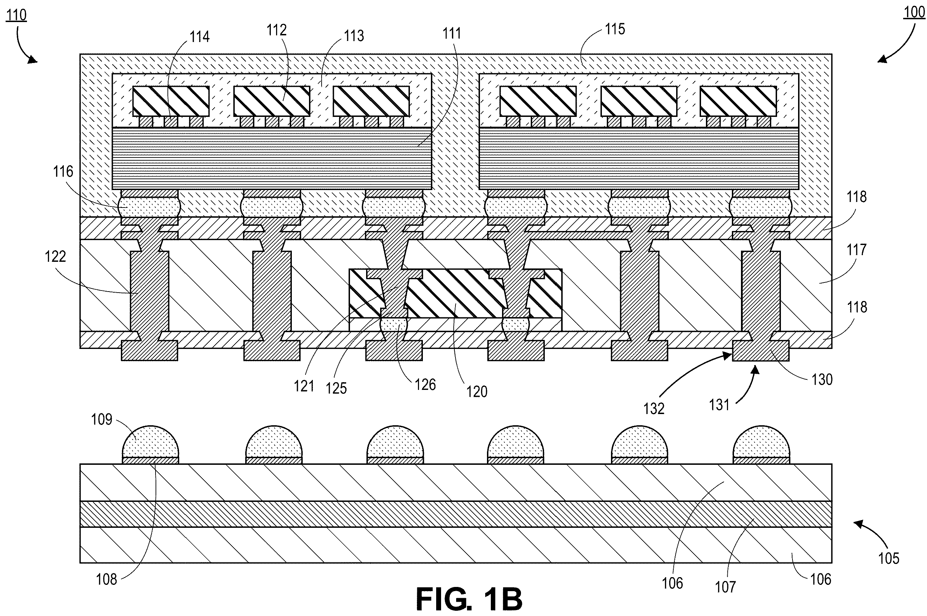

Referring now to Figure 1B, a cross-sectional illustration of an electronic system 100 is shown, in accordance with an embodiment. In an embodiment, the electronic system 100 in Figure 1B is similar to the electronic system 100 in Figure 1A, with the exception of the MLI pads 130. As shown, the MLI pads 130 protrude from the RDL 118. For example, sidewalls 132 of the MLI pads 130 are exposed above the RDL 118. Additionally, the bottom surfaces 131 of the MLI pads 130 are no longer coplanar with the bottom surface of the RDL 118.

In the illustrated embodiment, the MLI pads 130 comprise substantially vertical sidewalls 132. That is, the sidewalls 132 may be substantially orthogonal to a bottom surface of the RDL 118. As shown in Figure 1B, the sidewalls 132 are not lined with a liner or the like. However, as will be described in greater detail herein, liners and/or passivation layers may be provided along the sidewalls 132. Further, electrically conductive etchstop layers and/or liners may be provided over the bottom surfaces 131 of the MLI pads 130 as well. Such embodiments will be described in greater detail herein.

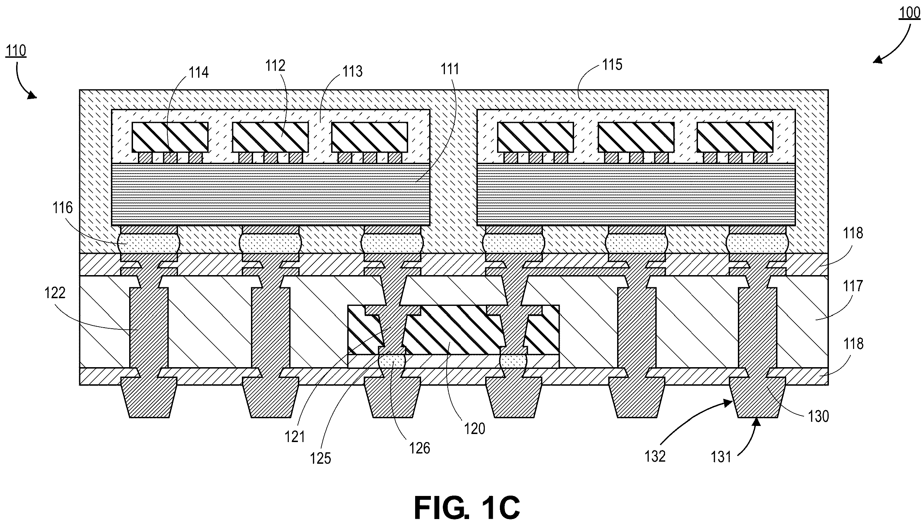

Referring now to Figure 1C, a cross-sectional illustration of an electronic system 100 is shown, in accordance with yet another embodiment. The electronic system 100 in Figure 1C may be similar to the electronic system 100 in Figure 1B, with the exception of the structure of the MLI pads 130. Instead of having substantially vertical sidewalls 132, the sidewalls 132 of the MLI pads 130 are tapered. The taper may have a wider top end (facing towards the dies 112) and a narrower bottom end (facing away from the dies 112). The direction of the taper of the sidewalls 132 may be an indication that the MLI pads 130 were formed at the beginning of the process flow (e.g., before the dies 112 were coupled to the layer 117).

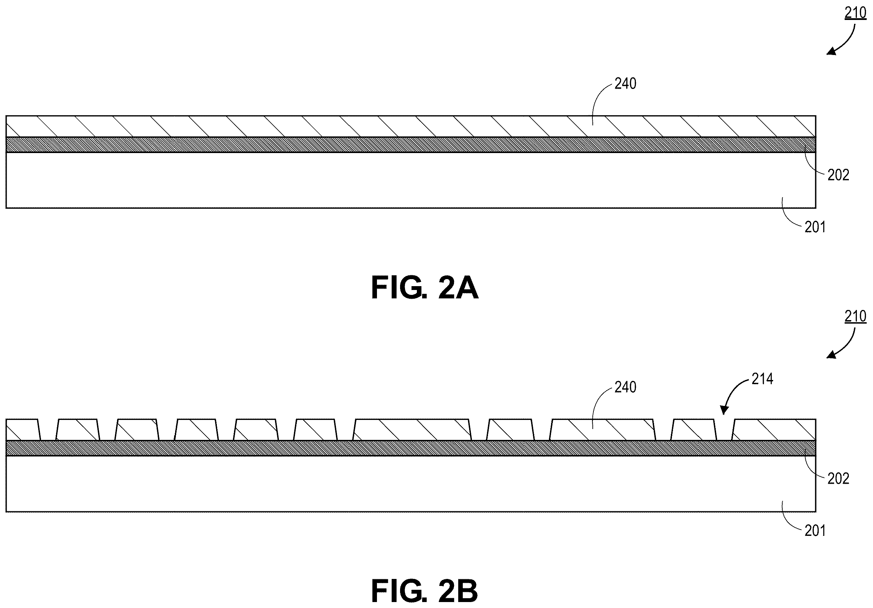

Referring now to Figures 2A - 2H, a series of cross-sectional illustrations that depict a process for forming a multichip patch 210 (or a patch 210 for short) is shown, in accordance with an embodiment. In an embodiment, the patch 210 may comprise protruding MLI pads 230 that have tapered sidewalls, similar to the embodiment described in greater detail above with respect to Figure 1C.

Referring now to Figure 2A, a cross-sectional illustration of a patch 210 at a stage of manufacture is shown, in accordance with an embodiment. In an embodiment, the patch 210 may be fabricated on a carrier 201. The carrier 201 may be a glass carrier, a silicon carrier, or any other suitably flat and rigid surface. A release layer 202 (e.g., a laser release layer or the like) may be formed over the carrier 201. In an embodiment, a dielectric layer 240 may be applied over the release layer 202. The dielectric layer 240 may be a laminated buildup film or the like.

Referring now to Figure 2B, a cross-sectional illustration of the patch 210 after openings 214 are formed through a thickness of the dielectric layer 240 is shown, in accordance with an embodiment. In an embodiment, the openings 214 may be formed with a laser ablation process or the like. When a laser is used, the openings 214 may have tapered sidewalls with narrow ends of the openings 214 closest to the carrier 201. While a laser patterning process is described, other patterning options, such as an etching process, may also be used in some embodiments.

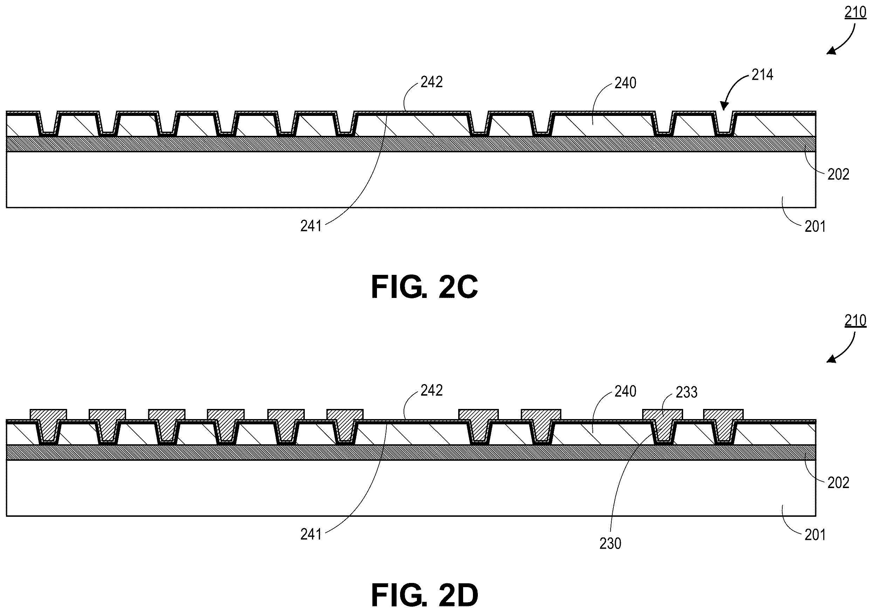

Referring now to Figure 2C, a cross-sectional illustration of the patch 210 after a seed layer 241, 242 is applied over the dielectric layer 240 is shown, in accordance with an embodiment. In an embodiment, the seed layer may comprise a sputtered electrically conductive layer 241, such as titanium, and a seed layer 242 comprising copper over the electrically conductive layer 241. Though, it is to be appreciated that any suitable seed layer (or layers) suitable for plating electrically conductive material may be used in other embodiments.

Referring now to Figure 2D, a cross-sectional illustration of the patch 210 after MLI pads 230 and underlying pads 233 are plated from the seed layer 241, 242 is shown, in accordance with an embodiment. In an embodiment, the MLI pads 230 and the underlying pads 233 may be formed with a semi-additive process (SAP) using a patterned resist layer (not shown). Though, in other embodiments, a blanket metal layer may be plated and subsequently patterned to define the underlying pads 233.

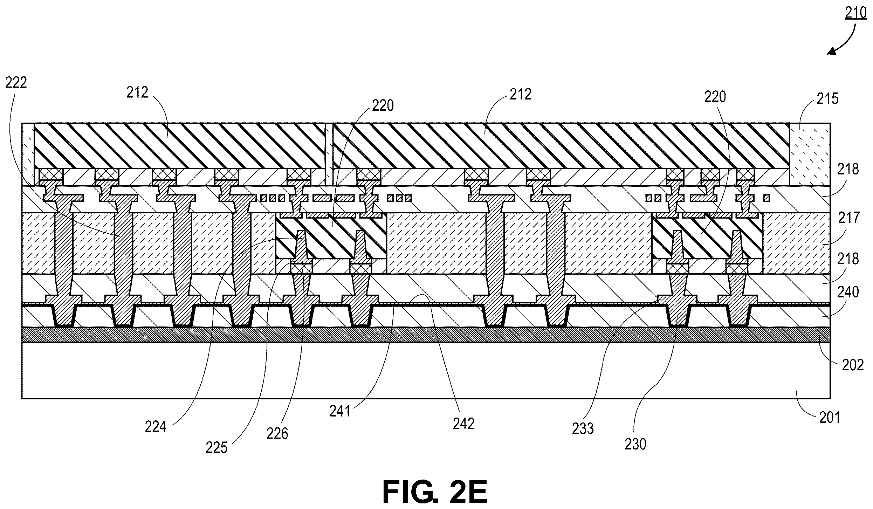

Referring now to Figure 2E, a cross-sectional illustration of the patch 210 after the remainder of the patch 210 is formed over the carrier 201. For example, RDLs 218 over and under a layer 217 may be formed. In an embodiment, bridges 220 may be embedded in the layer 217. The bridges 220 may be electrically coupled to electrical routing in the RDL 218 by pads 225 and corresponding interconnects 226. Vias 224 within the bridges 220 may electrically couple a routing layer at a top of the bridge 220 to the pads 225 and interconnects 226.

In an embodiment, vias 222 may pass through at least a thickness of the layer 217 in some embodiments in order to electrically couple routing within the bottom RDL 218 to routing within the top RDL 218. In an embodiment, a pair of dies 212 may be electrically coupled together through the bridge 220. For example, the dies 212 may be electrically coupled to the top RDL 218 by interconnects, such as solder or the like. In an embodiment, the dies 212 may be embedded in a mold layer 215 or the like.

In the illustrated embodiment, the bridge 220 on the right side of the patch 210 may only be coupled to a single die 212. For example, this bridge 220 may also be referred to as a component. In an embodiment, the component may be a passive component, an active component, or the like. For example, the component may provide some utility to the overlying die 212 as opposed to electrically coupling two dies 212 together.

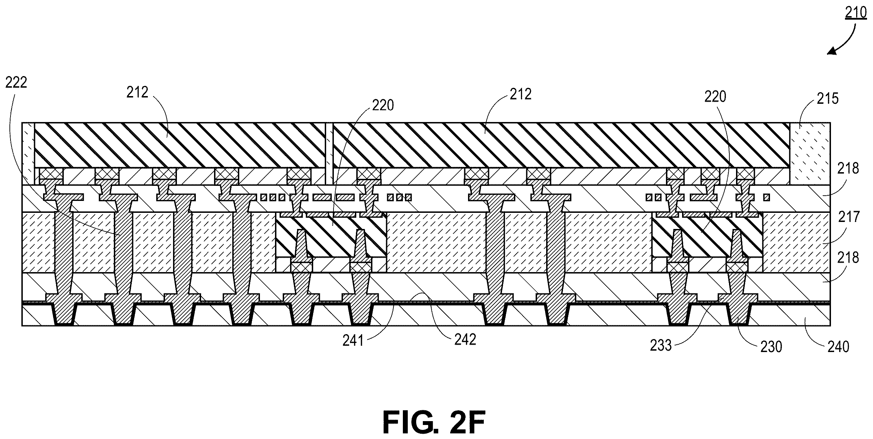

Referring now to Figure 2F, a cross-sectional illustration of the patch 210 after the carrier 201 and the release layer 202 are removed is shown, in accordance with an embodiment. In an embodiment, the release layer 202 may be deactivated with a laser exposure through the carrier 201. The adhesiveness of the release layer 202 is reduced in order to allow the carrier 201 and the release layer 202 to be removed.

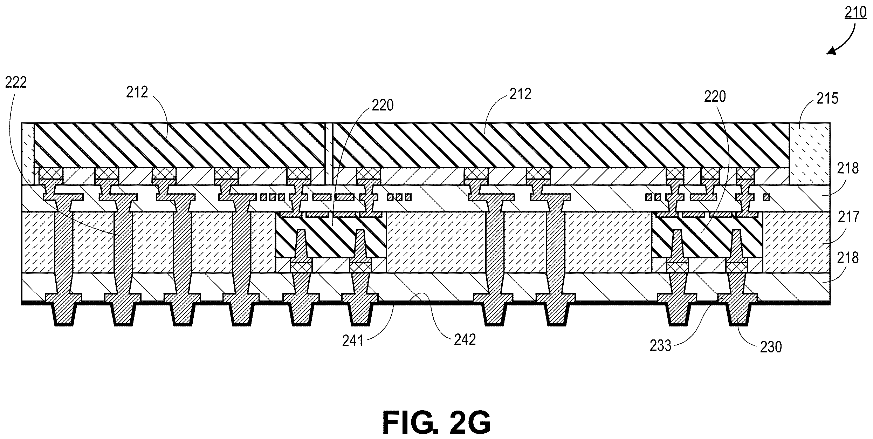

Referring now to Figure 2G, a cross-sectional illustration of the patch 210 after the dielectric layer 240 is removed is shown, in accordance with an embodiment. In an embodiment, the dielectric layer 240 may be removed with an etching process or the like. The etching process may entirely remove the dielectric layer 240, and the seed layer 241, 242 protects the underlying RDL 218 from redeposition of electrically conductive material.

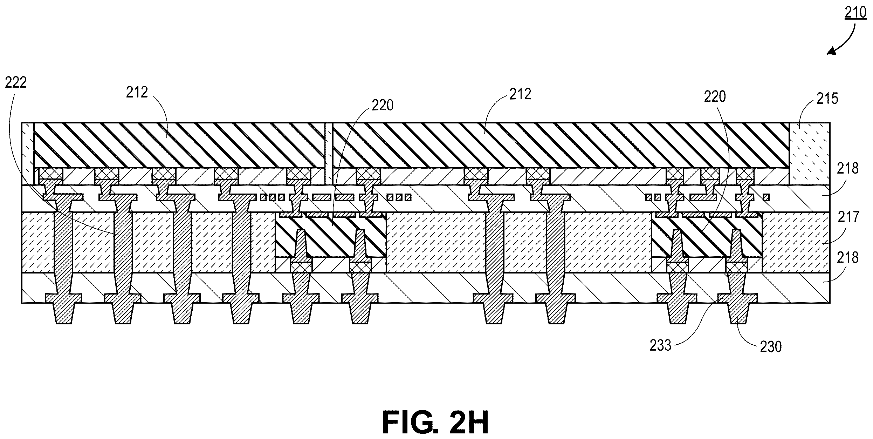

Referring now to Figure 2H, a cross-sectional illustration of the patch 210 after the seed layer 241, 242 is removed is shown, in accordance with an embodiment. In an embodiment, the seed layer 241, 242 may be removed with a seed etching process. As such, the MLI pads 230 are now electrically isolated from each other and protruding from the RDL 218.

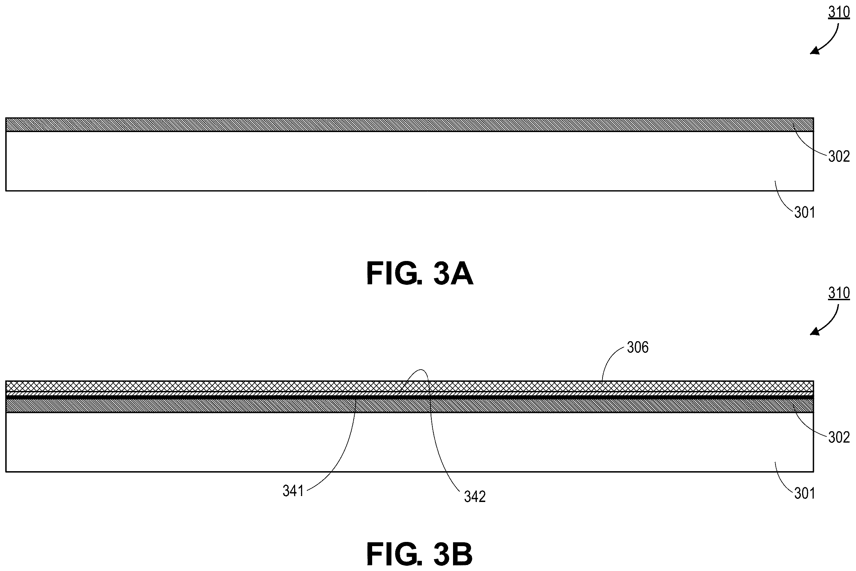

Referring now to Figures 3A - 3N, a series of cross-sectional illustrations that depict a process for forming a multichip patch 310 (or a patch 310 for short) is shown, in accordance with an embodiment. In an embodiment, the patch 310 may comprise protruding MLI pads 330 that have substantially vertical sidewalls, similar to the embodiment described in greater detail above with respect to Figure 1B. However, the embodiments shown in Figures 3A - 3N may also include a passivation layer (which may sometimes also be referred to as a liner) along sidewalls of the MLI pads 330. The use of a passivation layer improves the process flow in addition to serving as a diffusion barrier to prevent electromigration.

Referring now to Figure 3A, a cross-sectional illustration of a patch 310 at a stage of manufacture is shown, in accordance with an embodiment. In an embodiment, the patch 310 may be fabricated on a carrier 301. The carrier 301 may be a glass carrier, a silicon carrier, or any other suitably flat and rigid surface. A release layer 302 (e.g., a laser release layer or the like) may be formed over the carrier 301.

Referring now to Figure 3B, a cross-sectional illustration of the patch 310 after a seed layer 341, 342 and a patterning layer 306 are formed over the release layer 302 is shown, in accordance with an embodiment. In an embodiment, the seed layer may comprise a sputtered electrically conductive layer 341, such as titanium, and a seed layer 342 comprising copper over the electrically conductive layer 341. Though, it is to be appreciated that any suitable seed layer (or layers) suitable for plating electrically conductive material may be used in other embodiments. In an embodiment, the patterning layer 306 may be a laminated resist layer or the like.

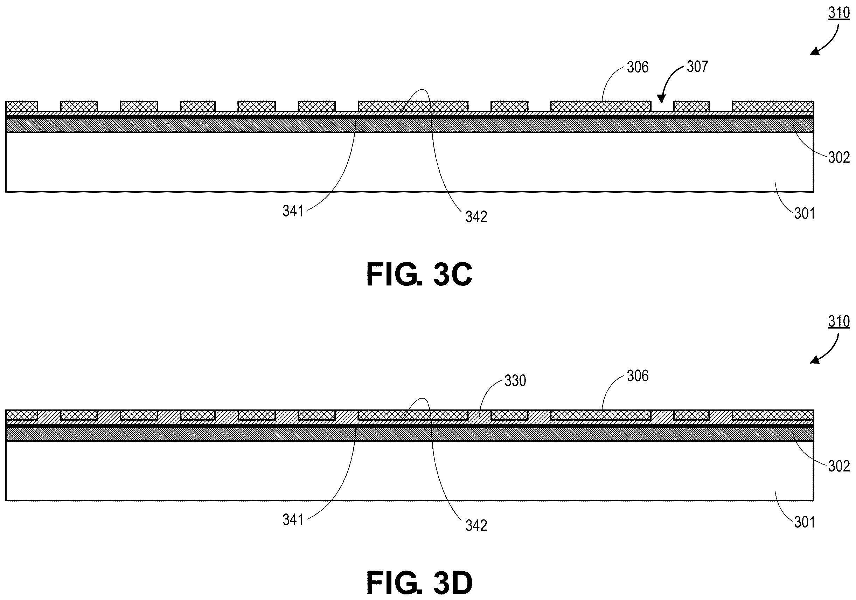

Referring now to Figure 3C, a cross-sectional illustrations of the patch 310 after openings 307 are formed through the patterning layer 306 is shown, in accordance with an embodiment. In an embodiment, the openings 307 may be formed with an etching process or a laser ablation process or the like. When an etching process is used, the openings 307 may have substantially vertical sidewalls.

Referring now to Figure 3D, a cross-sectional illustration of the patch 310 after MLI pads 330 are formed is shown, in accordance with an embodiment. In an embodiment, the MLI pads 330 may be plated up from the seed layer 342 with any suitable plating process.

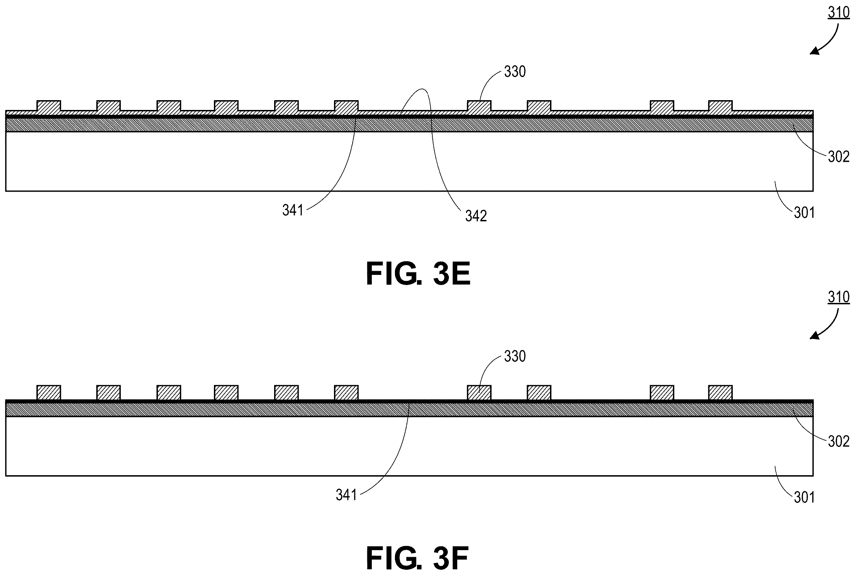

Referring now to Figure 3E, a cross-sectional illustration of the patch 310 after the patterning layer 306 is removed is shown, in accordance with an embodiment. In an embodiment, the patterning layer 306 may be removed with a resist stripping process, an etching process, or the like.

Referring now to Figure 3F, a cross-sectional illustration of the patch 310 after the copper seed layer 342 is etched is shown, in accordance with an embodiment. In an embodiment, removal of the seed layer 342 may expose the underlying titanium seed layer 341.

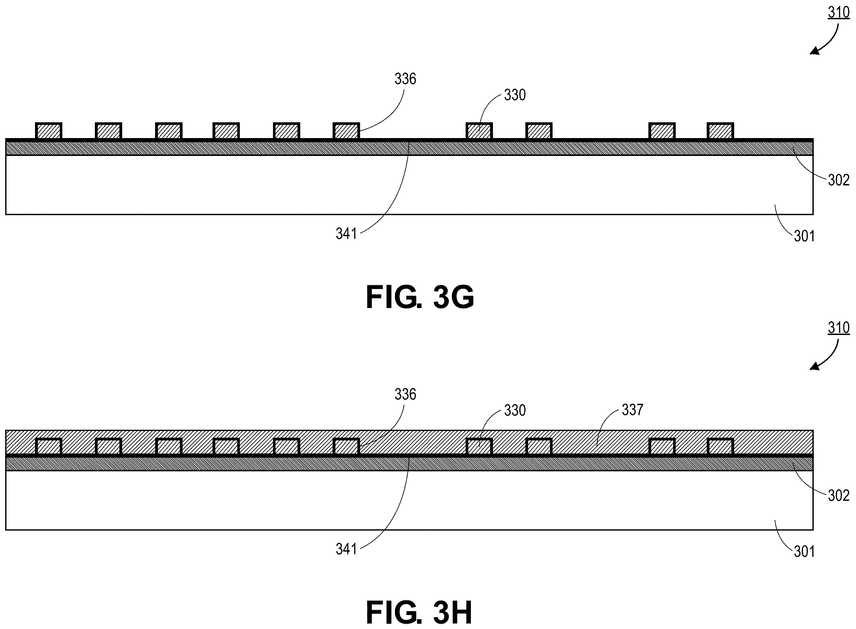

Referring now to Figure 3G, a cross-sectional illustration of the patch 310 after a passivation layer 336 is formed over the MLI pads 330 is shown, in accordance with an embodiment. In an embodiment, the passivation layer 336 may comprise the same material as the seed layer 342. Though, in other embodiments, the passivation layer 336 may comprise a different material than the seed layer 342. In an embodiment, the passivation layer 336 may comprise a material that is etch selective to the MLI pads 330, such as titanium, nickel, gold, silicon nitride, silicon oxide, or the like.

Referring now to Figure 3H, a cross-sectional illustration of the patch 310 after an electrically conductive layer 337 is formed over and around the MLI pads 330 is shown, in accordance with an embodiment. For example, a seed layer (not shown) may be applied over the passivation layer 336, and the conductive layer 337 may be plated up from the seed layer that is over the passivation layer 336. In an embodiment, the conductive layer 337 may comprise the same material as the MLI pads 330, such as copper or the like.

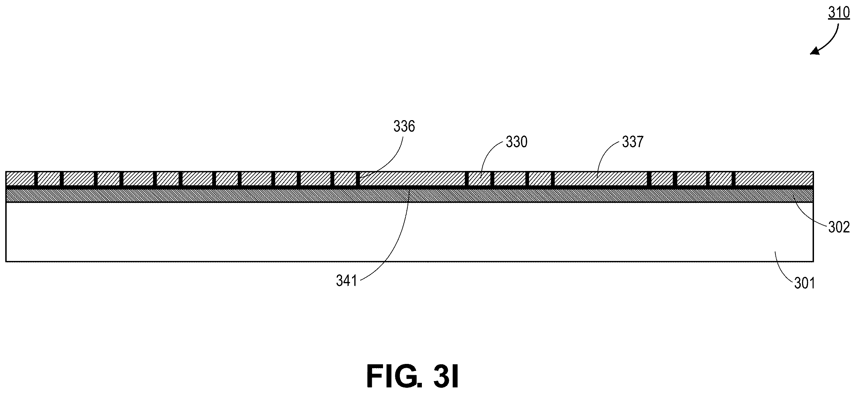

Referring now to Figure 3I, a cross-sectional illustration of the patch 310 after the conductive layer 337 is recessed is shown, in accordance with an embodiment. In an embodiment, the conductive layer 337 may be recessed with a polishing process, such as a chemical mechanical planarization (CMP) process or the like. The planarization process may also result in the removal of a portion of the passivation layer 336 over a top surface of the MLI pads 330. As such, the top surfaces of the MLI pads 330 may now be exposed.

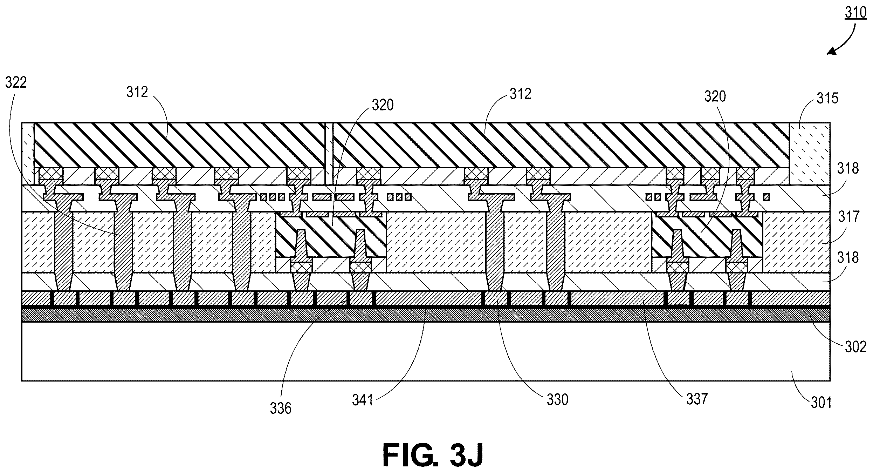

Referring now to Figure 3J, a cross-sectional illustration of the patch 310 after the remainder of the patch 310 is formed over the carrier 301 is shown, in accordance with an embodiment. For example, RDLs 318 over and under a layer 317 may be formed. In an embodiment, bridges 320 may be embedded in the layer 317. The bridges 320 may be electrically coupled to electrical routing in the RDL 318 by pads on the bridges 320 and corresponding interconnects below the pads. Vias within the bridges 320 may electrically couple a routing layer at a top of the bridge 320 to the pads and interconnects below the pads.

In an embodiment, vias 322 may pass through at least a thickness of the layer 317 in some embodiments in order to electrically couple routing within the bottom RDL 318 to routing within the top RDL 318. In an embodiment, a pair of dies 312 may be electrically coupled together through the bridge 320. For example, the dies 312 may be electrically coupled to the top RDL 318 by interconnects, such as solder bumps or the like. In an embodiment, the dies 312 may be embedded in a mold layer 315 or the like.

In the illustrated embodiment, the bridge 320 on the right side of the patch 310 may only be coupled to a single die 312. For example, this bridge 320 may also be referred to as a component. In an embodiment, the component may be a passive component, an active component, or the like. For example, the component may provide some utility to the overlying die 312 as opposed to electrically coupling two dies 312 together.

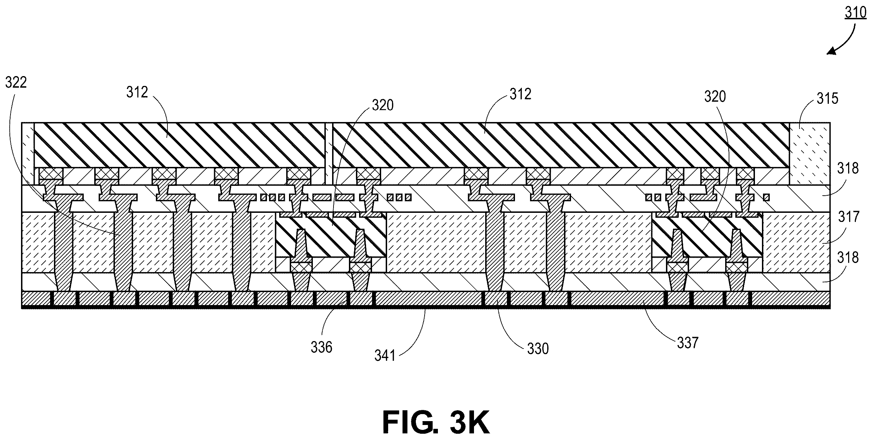

Referring now to Figure 3K, a cross-sectional illustration of the patch 310 after the carrier 301 and the release layer 302 are removed is shown, in accordance with an embodiment. In an embodiment, the release layer 302 may be deactivated with a laser exposure through the carrier 301. The adhesiveness of the release layer 302 is reduced in order to allow the carrier 301 and the release layer 302 to be removed.

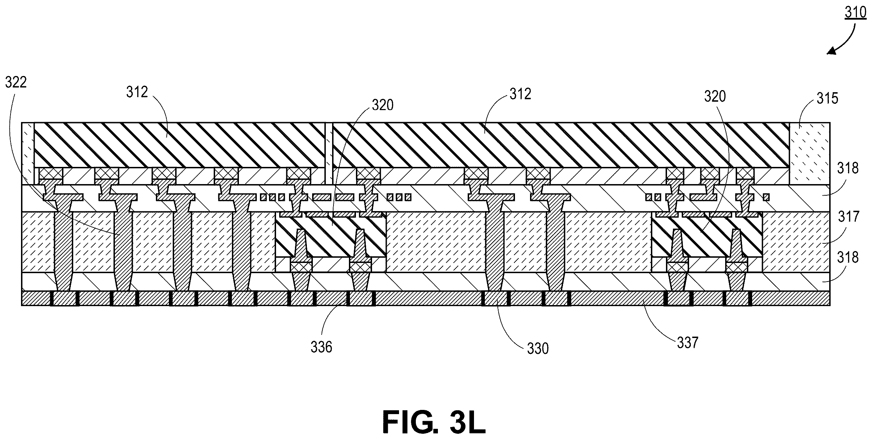

Referring now to Figure 3L, a cross-sectional illustration of the patch 310 after the seed layer 341 is removed is shown, in accordance with an embodiment. In an embodiment, the seed layer 341 may be removed with an etching process or the like.

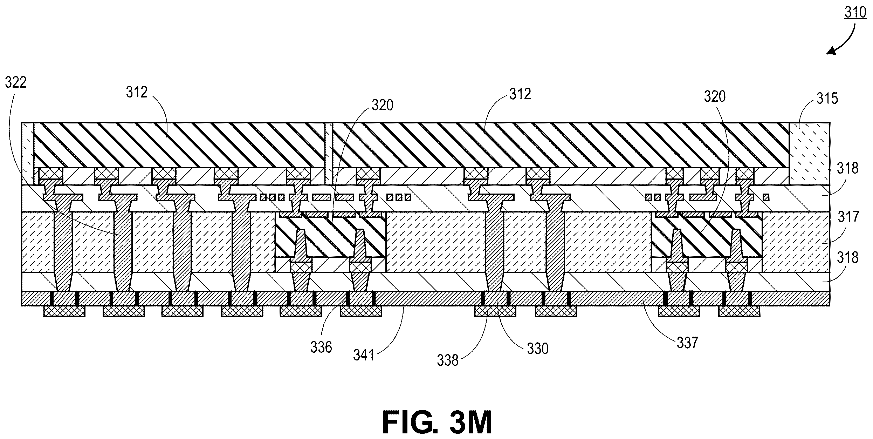

Referring now to Figure 3M, a cross-sectional illustration of the patch 310 after a resist layer 338 is formed over the conductive layer 337 and the MLI pads 330 and patterned is shown, in accordance with an embodiment. In an embodiment, the resist layer 338 may be patterned so that the surfaces of the MLI pads 330 are covered.

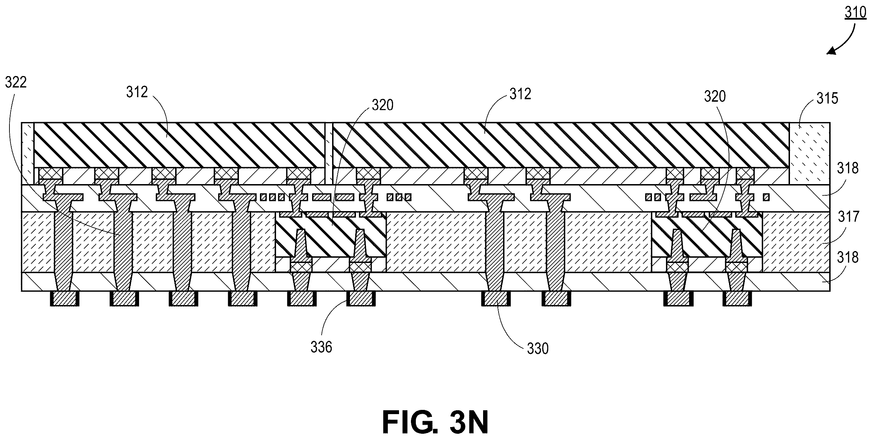

Referring now to Figure 3N, a cross-sectional illustration of the patch 310 after the conductive layer 337 and the resist layer 338 are removed is shown, in accordance with an embodiment. In an embodiment, the conductive layer 337 may be removed with an etching process, and the resist layer 338 may be removed with a resist stripping process or the like. As shown, the resulting MLI pads 330 protrude from the RDL 318 and have sidewalls that are lined by the passivation layer 336.

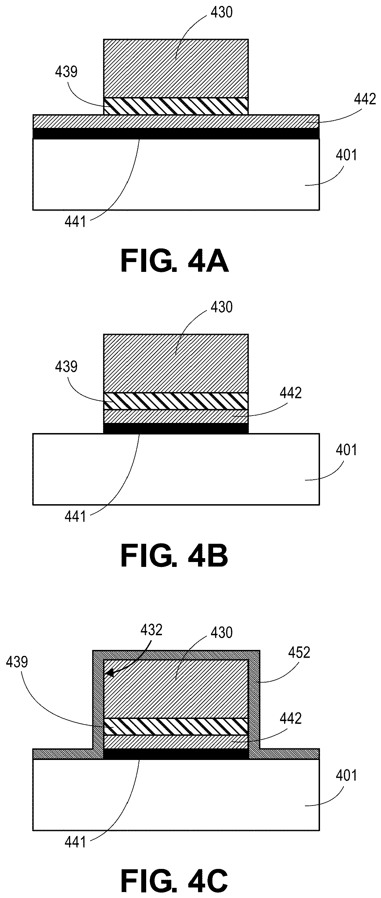

Additional embodiments described herein illustrate alternative ways to form a protruding MLI pad. In the additional embodiments, alternative passivation and/or etchstop architectures are shown that enable MLI pad first fabrication. In the following illustrated embodiments, the Figures are zoomed in on a single MLI pad. Though, it is to be appreciated that patch structures similar to those described above may be fabricated to have MLI pads similar to those described with respect to Figures 4A - 5H,

Referring now to Figure 4A, a cross-sectional illustration of an MLI pad 430 formed over a carrier 401 is shown, in accordance with an embodiment. In an embodiment, the MLI pad 430 may be separated from the carrier 401 by a seed layer 441, 442 and an etchstop layer 439. In an embodiment, the etchstop layer 439 may comprise an electrically conductive material that is etch selective to the MLI pad 430. For example, when the MLI pad 430 comprises copper, the etchstop layer 439 may comprise gold, nickel, or the like. In some embodiments, a copper buffer layer (not shown) may be provided at one or more of the interfaces between different layers shown in Figure 4A. In an embodiment, the MLI pad 430 and the etchstop layer 439 may be formed with an SAP technique or the like.

Referring now to Figure 4B, a cross-sectional illustration of the MLI pad 430 after the seed layer 441, 442 is patterned is shown, in accordance with an embodiment. In an embodiment, the seed layer 441, 442 may be patterned with an etching process to expose the underlying carrier 401 on the sides of the MLI pad 430.

Referring now to Figure 4C, a cross-sectional illustration of the MLI pad 430 after a passivation layer 452 is formed over the MLI pad 430 is shown, in accordance with an embodiment. In an embodiment, the passivation layer 452 may cover sidewalls 432 and a top surface of the MLI pad 430. In an embodiment, the passivation layer 452 may comprise one or more electrically conductive materials, such as gold and/or nickel. The passivation layer 452 may be deposited with an electroplating process, a sputtering process, or the like. In an embodiment, the passivation layer 452 may comprise the same material composition as the etchstop layer 439, or the passivation layer 452 may comprise a different material composition than the etchstop layer 439.

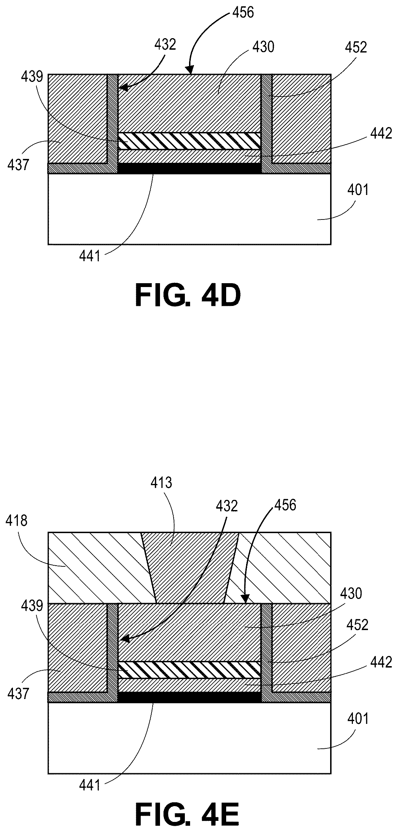

Referring now to Figure 4D, a cross-sectional illustration after a conductive layer 437 is formed around the MLI pad 430 is shown, in accordance with and embodiment. In an embodiment, the conductive layer 437 may be deposited to a thickness that is greater than a height of the MLI pad 430. The excess conductive layer 437 (and a portion of the passivation layer 452 over a top surface 456 of the MLI pad 430) may be removed with a polishing process (e.g., CMP) in order to expose the top surface 456 of the MLI pad 430.

Referring now to Figure 4E, a cross-sectional illustration of the MLI pad 430 after a remaining portion of the patch is fabricated over the MLI pad 430. In the illustrated embodiment, an RDL 418 with a via 413 is shown. However, it is to be appreciated that the patch may be similar to any of the multichip patch architectures described in greater detail herein.

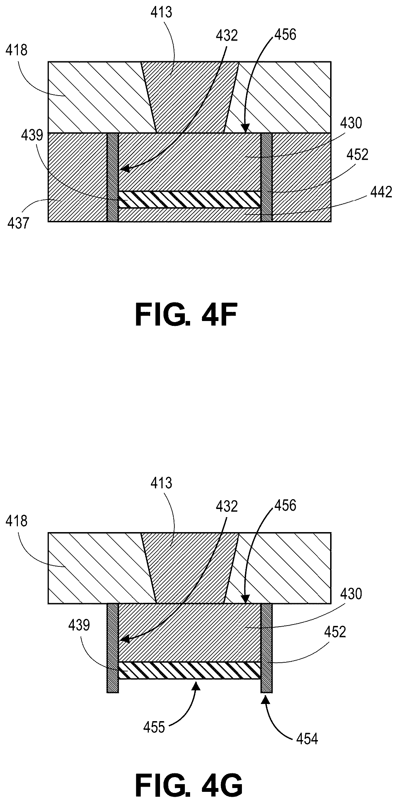

Referring now to Figure 4F, a cross-sectional illustration of the MLI pad 430 after the carrier 401 is removed is shown, in accordance with an embodiment. In an embodiment, the carrier 401 may be removed by releasing a release layer (not shown) that is provided between the structure and the carrier 401. After the carrier 401 is removed, a bottom portion of the passivation layer 452 and the seed layer 441 may be removed. For example a CMP process and/or an etching process may be used to remove the portion of the passivation layer 452 and the seed layer 441.

Referring now to Figure 4G, a cross-sectional illustration of the MLI pad 430 after the conductive layer 437 and the seed layer 442 are removed is shown, in accordance with an embodiment. In an embodiment, the conductive layer 437 and the seed layer 442 may be removed with an etching process or the like. The etchstop layer 439 and the passivation layer 452 may protect the MLI pad 430 from the etching chemistry.

As shown, the resulting structure may have the passivation layer 452 extending past a bottom surface 455 of the etchstop layer 439. For example, the bottom surface 454 of the passivation layer 452 may be offset from the bottom surface 455 of the etchstop layer 439.

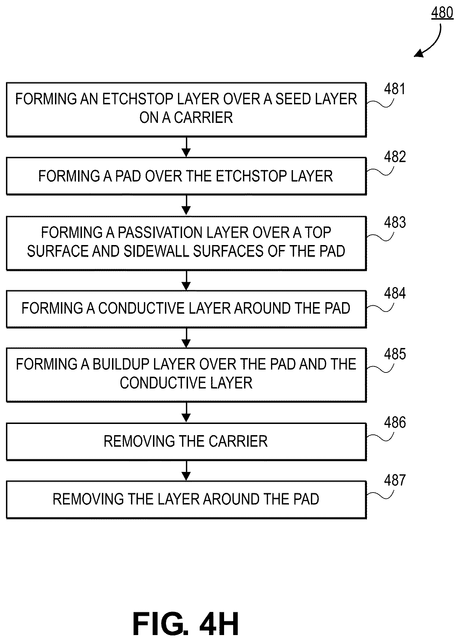

Referring now to Figure 4H, a flow diagram that describes a process 480 for forming an MLI pad is shown, in accordance with an embodiment. In an embodiment, the process 480 may be similar to any of the embodiments described above with respect to Figures 4A - 4G. In an embodiment, the process 480 may begin with operation 481, which comprises forming an etchstop layer over a seed layer on a carrier. In an embodiment, the process 480 may continue with operation 482, which comprises forming a pad over the etchstop layer. The pad may be an MLI pad. In an embodiment, the process 480 may continue with operation 483, which comprises forming a passivation layer over a top surface and sidewall surfaces of the pad. In an embodiment, the passivation layer and the etchstop layer may have the same or substantially the same material compositions or different material compositions.

In an embodiment, the process 480 may continue with operation 484, which comprises forming a conductive layer around the pad. In an embodiment, the conductive layer may be recessed along with a portion of the passivation layer over the top surface of the pad to expose the pad. In an embodiment, the process 480 may continue with operation 485, which comprises forming a buildup layer over the pad and the conductive layer. In an embodiment, the buildup layer may be part of a multichip patch, such as any of the multichip patches described in greater detail herein.

In an embodiment, the process 480 may continue with operation 486, which comprises removing the carrier. In an embodiment, the process 480 may continue with operation 487, which comprises removing the conductive layer around the pad. In an embodiment, any portion of the seed layer remaining on a surface of the etchstop layer opposite from the pad may also be removed.

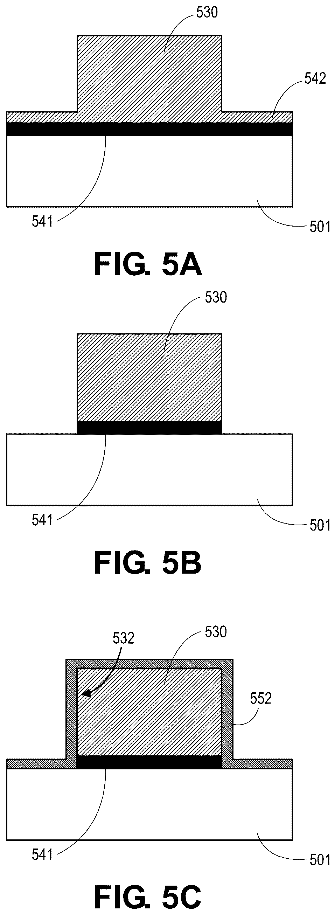

Referring now to Figure 5A, a cross-sectional illustration of an MLI pad 530 formed over a carrier 501 is shown, in accordance with an embodiment. In an embodiment, the MLI pad 530 may be separated from the carrier 501 by a seed layer 541, 542. In an embodiment, the MLI pad 530 may be formed with an SAP technique or the like.

Referring now to Figure 5B, a cross-sectional illustration of the MLI pad 530 after the seed layer 541, 542 is patterned is shown, in accordance with an embodiment. In an embodiment, the seed layer 541, 542 may be patterned with an etching process to expose the underlying carrier 501 on the sides of the MLI pad 530.

Referring now to Figure 5C, a cross-sectional illustration of the MLI pad 530 after a passivation layer 552 is formed over the MLI pad 530 is shown, in accordance with an embodiment. In an embodiment, the passivation layer 552 (which may sometimes also be referred to as a liner) may cover sidewalls 532 and a top surface of the MLI pad 530. In an embodiment, the passivation layer 552 may be electrically conductive or electrically insulating. For example, the passivation layer 552 may comprise one or more materials, such as gold, nickel, silicon and nitrogen (e.g., silicon nitride), and/or silicon and oxygen (e.g., silicon oxide). The passivation layer 552 may be deposited with an electroplating process, a sputtering process, or the like. In the case of an electroplated layer, a seed layer (not shown) may be applied to initiate the plating.

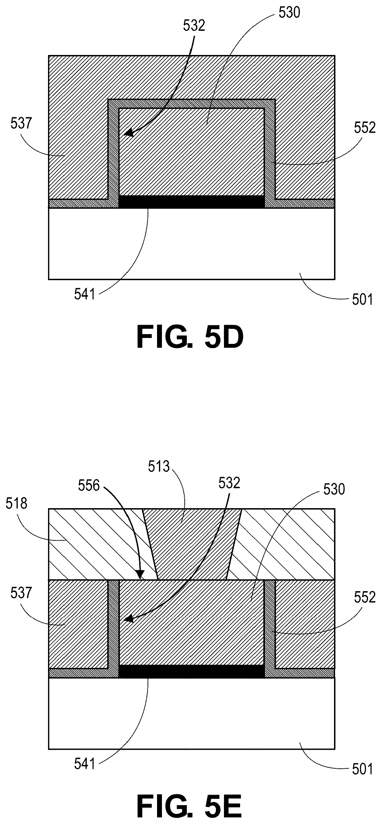

Referring now to Figure 5D, a cross-sectional illustration after a conductive layer 537 is formed around the MLI pad 530 is shown, in accordance with and embodiment. In an embodiment, the conductive layer 537 may be deposited to a thickness that is greater than a height of the MLI pad 530. In some embodiments, a seed layer (not shown) may be applied over the passivation layer 552, and the conductive layer 537 is plated up from the seed layer. The excess conductive layer 537 (and a portion of the passivation layer 552 over a top surface of the MLI pad 530) may be removed with a polishing process (e.g., CMP) in order to expose the top surface of the MLI pad 530.

Referring now to Figure 5E, a cross-sectional illustration of the MLI pad 530 after a remaining portion of the patch is fabricated over the MLI pad 530. In the illustrated embodiment, an RDL 518 with a via 513 landing on the top surface 556 of the MLI pad 530 is shown. However, it is to be appreciated that the patch may be similar to any of the multichip patch architectures described in greater detail herein.

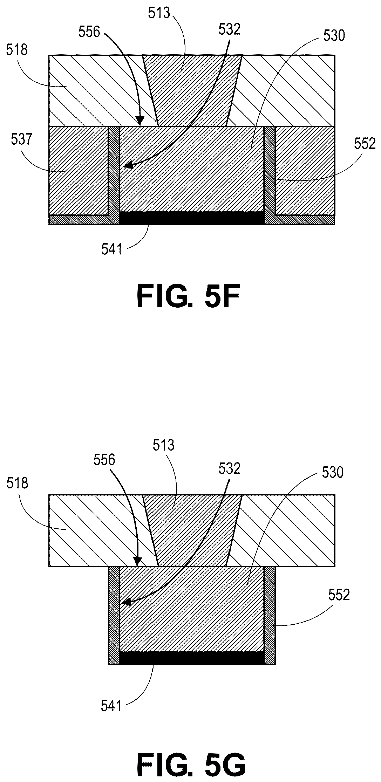

Referring now to Figure 5F, a cross-sectional illustration of the MLI pad 530 after the carrier 501 is removed is shown, in accordance with an embodiment. In an embodiment, the carrier 501 may be removed by releasing a release layer (not shown) that is provided between the structure and the carrier 501.

Referring now to Figure 5G, a cross-sectional illustration of the MLI pad 530 after a bottom portion of the passivation layer 552 and the conductive layer 537 are removed is shown, in accordance with an embodiment. In an embodiment, the exposed portions of the passivation layer 552 may be removed with a selective etching process. Thereafter, the conductive layer 537 may be removed with a second selective etching process. In an embodiment, the seed layer 541 and the passivation layer 552 may protect the MLI pad 530 from the etching chemistry.

As shown, the bottom of the passivation layer 552 along sidewalls 532 of the MLI pad 530 is substantially coplanar with the bottom surface of the seed layer 541. Though, in some embodiments, the etching process to remove portions of the passivation layer 552 over the conductive layer 537 may partially etch the sidewall portion of the passivation layer 552. As such, the bottom surface of the seed layer 541 may be offset from the bottom surface of the passivation layer 552.

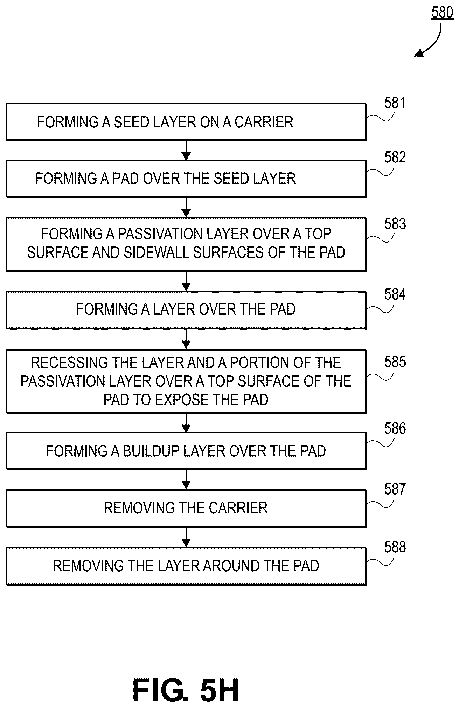

Referring now to Figure 5H, a flow diagram that describes a process 580 for forming an MLI pad is shown, in accordance with an embodiment. In an embodiment, the process 580 may be similar to any of the embodiments described above with respect to Figures 5A - 5G. In an embodiment, the process 580 may begin with operation 581, which comprises forming a seed layer on a carrier. In an embodiment, the process 580 may continue with operation 582, which comprises forming a pad over the seed layer. The pad may be an MLI pad. In an embodiment, the process 580 may continue with operation 583, which comprises forming a passivation layer over a top surface and sidewall surfaces of the pad.

In an embodiment, the process 580 may continue with operation 584, which comprises forming a conductive layer around the pad. In an embodiment, the conductive layer may be plated up from a seed layer formed over the passivation layer. In an embodiment, the process 580 may continue with operation 585, which comprises recessing the conductive layer and a portion of the passivation layer over a top surface of the pad to expose the pad. In an embodiment, the process 580 may continue with operation 586, which comprises forming a buildup layer over the pad and the conductive layer. In an embodiment, the buildup layer may be part of a multichip patch, such as any of the multichip patches described in greater detail herein.

In an embodiment, the process 580 may continue with operation 587, which comprises removing the carrier. In an embodiment, the process 580 may continue with operation 588, which comprises removing the conductive layer around the pad. In an embodiment, any portion of the passivation layer over the conductive layer may also be removed (e.g., with an etching process).

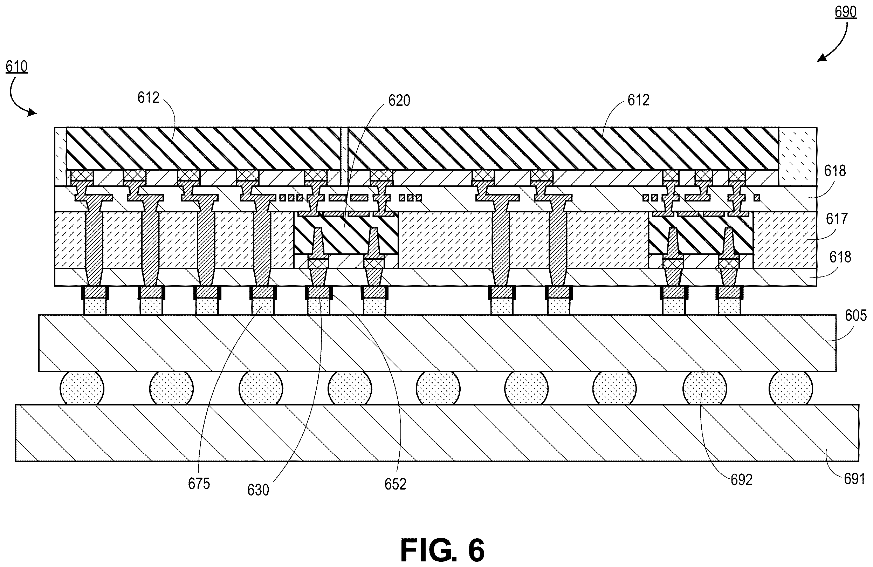

Referring now to Figure 6, a cross-sectional illustration of an electronic system 690 is shown, in accordance with an embodiment. In an embodiment, the electronic system 690 may comprise a board 691, such as a printed circuit board (PCB) or the like. In an embodiment, a substrate 605 (such as a package substrate, an interposer, or the like) may be electrically coupled to the board 691 by any suitable interconnect 692, such a second level interconnect (SLI) or the like. In an embodiment, a multichip patch 610 may be electrically coupled to the substrate 605 by MLIs 675. For example, the MLIs 675 may comprise any suitable interconnect material, such as a tin based solder or the like

In an embodiment, the multichip patch 610 may comprise protruding MLI pads 630. In an embodiment, the MLI pads 630 may comprise a liner 652 or other passivation layers, etchstop layers, or the like. In an embodiment, the MLI pads 630 may be similar to any of the MLI pads described in greater detail herein. The MLI pads 630 may protrude from an RDL 618. A layer 617 over the RDL may embed one or more bridges 620 or other components (e.g., a passive component, an active component, or the like). In an embodiment, one or more dies 612 may be electrically coupled to an upper RDL 618 by any suitable FLI architecture. More generally, the multichip patch 610 may be similar to any of the patches described in greater detail herein.

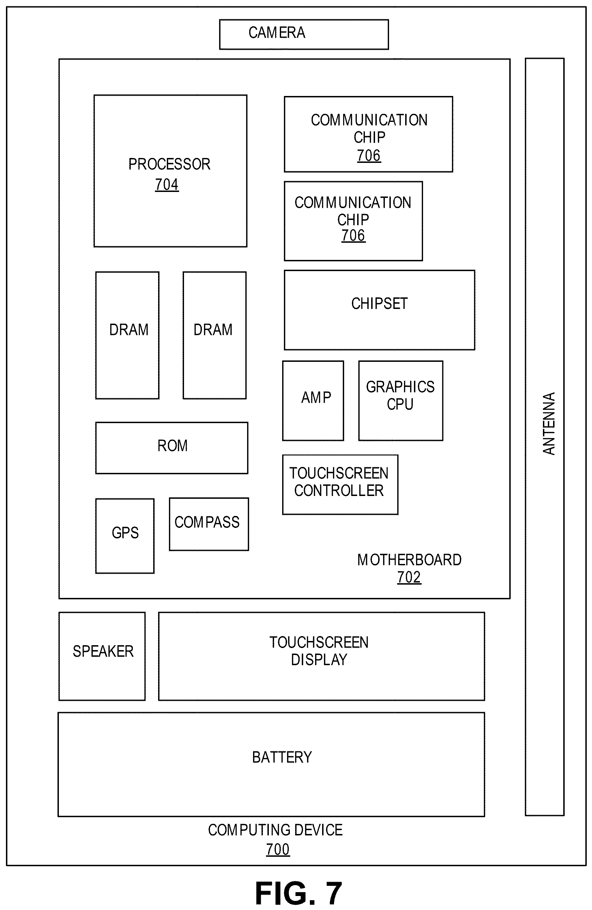

Figure 7 illustrates a computing device 700 in accordance with one implementation of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the disclosure, the integrated circuit die of the processor may be part of an electronic system that comprises a multichip patch with protruding MLI bumps, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the disclosure, the integrated circuit die of the communication chip may be part of an electronic system that comprises a multichip patch with protruding MLI bumps, in accordance with embodiments described herein.

In an embodiment, the computing device 700 may be part of any apparatus. For example, the computing device may be part of a personal computer, a server, a mobile device, a tablet, an automobile, or the like. That is, the computing device 700 is not limited to being used for any particular type of system, and the computing device 700 may be included in any apparatus that may benefit from computing functionality.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

### Examples:

Example 1. An apparatus, comprising: a component embedded in a substrate; a first die on a first surface of the substrate; a layer on a second surface of the substrate opposite from the first surface; a pad on the layer, wherein the pad extends away from the layer; and a liner on a sidewall of the pad.

Example 2: the apparatus of Example 1, wherein the liner comprises an electrically conductive material.

Example 3: the apparatus of Example 2, wherein the liner comprises one or more of gold, nickel, or titanium.

Example 4: the apparatus of Examples 1, wherein the liner comprises an electrically insulating material.

Example 5: the apparatus of Example 4, wherein the liner comprises silicon and one or both of nitrogen or oxygen.

Example 6: the apparatus of Examples 1-5, further comprising: a second liner over a third surface of the pad that faces away from the layer.

Example 7: the apparatus of Example 6, wherein the liner comprises a first material composition, and wherein the second liner comprises a second material composition.

Example 8: the apparatus of Example 7, wherein the first material composition is different than the second material composition.

Example 9: the apparatus of Example 8, wherein the first material composition is electrically insulating and the second material composition is electrically conductive.

Example 10: the apparatus of Example 7, wherein the first material composition and the second material composition are the same or substantially the same.

Example 11: the apparatus of Examples 1-10, wherein the liner extends past an end surface of the pad.

Example 12. An apparatus, comprising: a die patch, wherein the die patch comprises: a first substrate; an interconnect bridge embedded in the first substrate; a first die on the first substrate; a second die on the first substrate, wherein the interconnect bridge is configured to electrically couple the first die to the second die; and a first pad on a surface of the first substrate opposite from the first die and the second die, wherein the first pad protrudes from the surface of the first substrate; a second substrate with a second pad; and an interconnect between the first pad and the second pad.

Example 13: the apparatus of Example 12, wherein the first pad has sidewalls that are substantially orthogonal to the surface of the first substrate opposite from the first die and the second die.

Example 14: the apparatus of Example 12 or Example 13, wherein the first pad comprises tapered sidewalls.

Example 15: the apparatus of Examples 12-14, further comprising: a liner along a sidewall of the first pad.

Example 16: the apparatus of Example 15, wherein the liner is electrically conductive.

Example 17: the apparatus of Example 15, wherein the liner is electrically insulating.

Example 18: the apparatus of Examples 15-17, wherein the liner extends past an end of the first pad.

Example 19. A method, comprising: forming an etchstop layer over a seed layer on a carrier; forming a pad over the etchstop layer; forming a passivation layer over a top surface and sidewall surfaces of the pad; forming a conductive layer around the pad; recessing the conductive layer and the passivation layer to expose the top surface of the pad; forming a buildup layer over the pad; removing the carrier; and removing the conductive layer around the pad.

Example 20: the method of Example 19, wherein the etchstop layer is electrically conductive.

## Claims

1. An apparatus, comprising:
a component embedded in a substrate;
a first die on a first surface of the substrate;
a layer on a second surface of the substrate opposite from the first surface;
a pad on the layer, wherein the pad extends away from the layer; and
a liner on a sidewall of the pad.

2. The apparatus of claim 1, wherein the liner comprises an electrically conductive material.

3. The apparatus of claim 2, wherein the liner comprises one or more of gold, nickel, or titanium.

4. The apparatus of claim 1, wherein the liner comprises an electrically insulating material.

5. The apparatus of claim 4, wherein the liner comprises silicon and one or both of nitrogen or oxygen.

6. The apparatus of claim 1, 2, 3, 4 or 5, further comprising:
a second liner over a third surface of the pad that faces away from the layer.

7. The apparatus of claim 6, wherein the liner comprises a first material composition, and wherein the second liner comprises a second material composition.

8. The apparatus of claim 7, wherein the first material composition is different than the second material composition.

9. The apparatus of claim 8, wherein the first material composition is electrically insulating and the second material composition is electrically conductive.

10. The apparatus of claim 7, wherein the first material composition and the second material composition are substantially the same.

11. The apparatus of claim 1, 2, 3, 4, 5, 6, 7, 8, 9 or 10, wherein the liner extends past an end surface of the pad.

12. A method, comprising:
forming an etchstop layer over a seed layer on a carrier;
forming a pad over the etchstop layer;
forming a passivation layer over a top surface and sidewall surfaces of the pad;
forming a conductive layer around the pad;
recessing the conductive layer and the passivation layer to expose the top surface of the pad;
forming a buildup layer over the pad;
removing the carrier; and
removing the conductive layer around the pad.

13. The method of claim 12, wherein the etchstop layer is electrically conductive.
